# EUROPEAN PATENT APPLICATION

(11) **EP 2 832 688 A1**
(43) Date of publication of application: **04.02.2015**
(21) Application number: 12872589.2
(22) Date of filing: 31.03.2012
(51) Int. Cl.: C01B 31/02

(54) **METHOD FOR PREPARING GRAPHENE PAPER**

(71) Applicant: Ocean's King Lighting Science&Technology Co., Ltd., Guangdong 518054 (CN); Shenzhen Ocean's King Lighting Engineering Co., Ltd., Shenzhen, Guangdong 518054 (CN)
(72) Inventor: ZHOU, Mingjie, Shenzhen Guangdong 518054 (CN); YUAN, Xinsheng, Shenzhen Guangdong 518054 (CN); WANG, Yaobing, Shenzhen Guangdong 518054 (CN)
(74) Representative: Grosse, Rainer
(86) International application number: PCT/CN2012/073421
(87) International publication number: WO 2013/143147

(57) **Abstract**

Provided is a method for preparing graphene paper, comprising the followings steps: placing a clean substrate into a reaction chamber, then introducing protective gas into the reaction chamber to purge out air in the reaction chamber; heating the substrate at a temperature of 800 to 1100°C; continuously introducing carbonaceous material into the reaction chamber for 100 to 300min, stopping the introduction of carbonaceous material into the reaction chamber, and at the same time stopping heating of the substrate , then cooling the substrate at a rate of 5 to 30°C/min, finally, stopping the introduction of the protective gas, thereby obtaining graphene paper on the surface of said substrate.

## Description

### TECHNICAL FIELD

The present invention relates to the field of the preparation of graphene material, in particular to the method of preparing graphene paper.

### BACKGROUND ART

Graphene is a two-dimensional crystal of carbon atoms in the form of single- or multi-layer thin carbon materials found by Andre K. Geim et. al. from the University of Manchester in 2004. Due to its unique structure and optical properties, graphene has become a hot research topic in the field of carbon materials, nanotechnology, physics of condensed matter and functional materials, and has attracted many scientific and technological workers. Single-layer graphene has many excellent properties, such as 1. high strength, Young's modulus 1,100 GPa, fracture strength: 125GPa; 2. high thermal conductivity: 5,000 W/mK; 3. high conductivity, carrier transfer rate: 200,000 cm²/V*s and the like; graphene paper made of graphene, in addition to said characteristics above, has a higher hardness (almost twice the hardness of carbon steel) and tensile strength. However, there are fewer reports related to the preparation of graphene paper.

### DISCLOSURE OF THE INVENTION

The technical problem aimed to be solved of the present invention is to provide a method of preparing graphene paper in a simple and easy to operate manner.

A method of preparing graphene paper, comprising the following steps:
S1: placing a clean substrate into a reaction chamber, followed by introducing therein a protective gas, thereby purging out air in the reaction chamber;
S2: heating said substrate at a temperature of 800 to 1100°C;
S3: keep introducing a carbonaceous material into said reaction chamber for 100 to 300 min;
S4: stopping the introduction of carbonaceous material into the reaction chamber while stopping heating of said substrate, followed by cooling said substrate at a rate of 5 to 30°C/min; finally, stopping the introduction of said protective gas, thereby obtaining graphene paper on the surface of said substrate.

In the above-mentioned method of preparing graphene paper, in step S1, said protective gas is at least one of hydrogen gas, nitrogen gas and argon gas; the flow rate of the protective gas is 50 to 1000 sccm.

In the above-mentioned method of preparing graphene paper, in step S2, preferably, the temperature of heating said substrate is 900 to 1050°C.

In the above-mentioned method of preparing graphene paper, in step S3, said carbonaceous material is at least one of methane, ethane, acetylene and ethene. Herein, the flow rate of said carbonaceous material is 10 to 300sccm; carbonaceous material may also be ethanol.

As a preferable embodiment, said substrate is a copper foil, an iron foil, a nickel foil or a cobalt foil; when said substrate is a copper foil, an iron foil, a nickel foil or a cobalt foil, the method of the present invention further comprises a step of collecting graphene paper for further treatment after step S4:
S5: dissolving said substrate from step S4 using a dilute solution of an acid or a salt solution having a concentration of 0.01 to 0.5mol/L to obtain the graphene paper; further, said dilute solution of an acid is selected from dilute hydrochloric acid, dilute sulphuric acid or dilute nitric acid; said salt solution may be a solution of iron chloride.

The method of preparing graphene paper according to the present invention making use of chemical vapor deposition has the advantage of reacting under atmospheric pressure, simple equipment, simple and feasible operation, and easy to implement a mass production in producing graphene paper having less defect, uniform layers and high mechanical strength.

### BRIEF DESCRIPTION OF THE DRAWING

Figure 1 shows the flowchart of the method of preparing graphene paper of the preferable embodiment according to the present invention.
Figure 2 shows the TEM image of the graphene paper prepared by Example 1 according to the present invention.

### DETAILED DESCRIPTION OF THE EMBODIMENTS

The above and other objects, features, and advantages of the present invention will become more apparent from the following detailed description when taken in conjunction with the accompanying drawings and embodiments. It should be understood that the specific embodiments described herein are merely for illustrative purpose, rather than limiting the present invention.

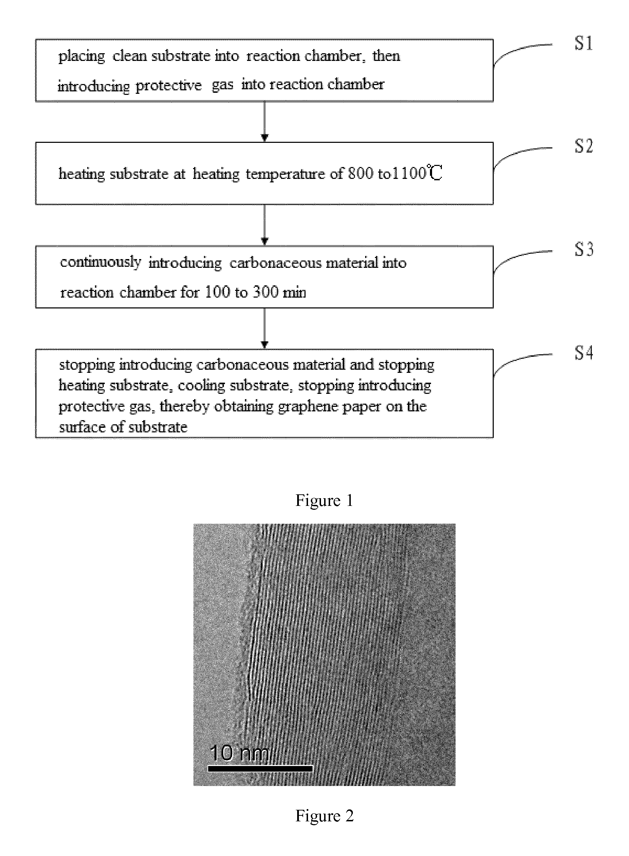

The present embodiment provides a method of preparing graphene paper, as shown in figure 1, comprising the following steps of:
S1: placing a clean substrate into a reaction chamber, followed by introducing therein a protective gas, thereby purging out air in the reaction chamber;
S2: heating said substrate at a temperature of 800 to1100°C;
S3: keep introducing a carbonaceous material into said reaction chamber for 100 to 300 min;
S4: stopping the introduction of carbonaceous material into the reaction chamber while stopping heating of said substrate, followed by cooling said substrate at a rate of 5 to 30°C/min; finally, stopping the introduction of said protective gas, thereby obtaining graphene paper on the surface of said substrate.

In the above-mentioned method of preparing graphene paper, in step S1, said protective gas is at least one of hydrogen gas, nitrogen gas and argon gas, preferably nitrogen gas is used as the protective gas. The main function of a protective gas is to provide an oxygen-free environment in the reaction chamber to avoid oxidation of the metallic substrate, while facilitating the cleavage reaction of the carbonaceous material; the flow rate of the protective gas is 50 to 1000 sccm; the reaction chamber should be in an atmosphere of protection, i.e. an oxygen-free environment, prior to the introduction of the carbonaceous material, and that duration time of introducing said protective gas is related to the size of the reaction space. Accordingly, prior to the introduction of the carbonaceous material, the preferred duration time of introducing said protective gas is 10 to 60 min.

In the above-mentioned method of preparing said graphene paper, in step S2, the temperature of heating the substrate is preferably 900 to 1050°C.

In the above-mentioned method of preparing said graphene paper, in step S3, preferably, carbonaceous material is at least one of methane, ethane, acetylene and ethene; meanwhile, the flow rate of said carbonaceous material is 10 to 300sccm; in addition, said carbonaceous material may be ethanol or gaseous carbonaceous compound.

As a preferable embodiment, the substrate is a copper foil, an iron foil, a nickel foil or a cobalt foil, said substrate has a thickness of 50 to 100um; when said substrate is a copper foil, an iron foil, a nickel foil or a cobalt foil, at the end of step S4, an additional step of collecting graphene paper for further treatment is included:

S5: said substrate from step S4 is dissolved using a dilute solution of an acid or a salt solution having a concentration of 0.01 to 0.5mol/L to obtain the graphene paper; meanwhile, said dilute solution of an acid is selected from dilute hydrochloric acid, dilute sulphuric acid or dilute nitric acid; said salt solution is a solution of iron chloride.

In the above-mentioned of preparing graphene paper, said reaction chamber is meant to the heating chamber of a muffle furnace, which said muffle furnace is provided with ventilation pipe at its both ends for ventilation and exhaustion.

The method of preparing graphene paper according to the present invention making use of chemical vapor deposition has the advantage of reacting under atmospheric pressure, simple equipment, simple and feasible operation, and easy to implement a mass production in producing graphene paper having less defect, uniform layers and high mechanical strength.

Detailed description to the preferable embodiments of the present invention will now be given with reference to the drawings.

### Example 1

1. A nickel foil having a thickness of 50um was placed into the heating chamber of a Muffle furnace, followed by introducing an argon gas into the heating chamber of the Muffle furnace at 200 sccm for 10 min;
2. the nickel foil was heated to 1100°C, and acetylene was introduced into the heating chamber of the Muffle furnace at 200 sccm for 200 min;
3. after the reaction, introduction of acetylene and heating of the nickel foil were stopped, and the nickel foil was cooled to room temperature at a rate of 10°C/min, followed by stopping the introduction of argon gas to obtain graphene paper on the nickel foil;
4. the nickel foil was dissolved using iron chloride having a concentration of 0.5mol/L to obtain the graphene paper.

Figure 2 shows the TEM image of the graphene paper prepared from Example 1; high-resolution TEM image of JOEL 3010 was used, it is shown that the graphene paper has uniform layers having a thickness of 13nm.

### Example 2

1. An iron foil having a thickness of 50um was placed into the heating chamber of a Muffle furnace, followed by introducing a hydrogen gas into the heating chamber of the Muffle furnace at 50 sccm for 60 min;
2. the iron foil was heated to 1050°C, and methane was introduced into the heating chamber of the Muffle furnace at 10 sccm for 300 min;
3. after the reaction, introduction of methane and heating of the iron foil were stopped, and the iron foil was cooled to room temperature at a rate of 30°C/min, followed by stopping the introduction of hydrogen gas to obtain graphene paper on the iron foil;
4. the iron foil was dissolved using a sulphuric acid having a concentration of 0.01 mol/L to obtain the graphene paper.

### Example 3

1. A copper foil having a thickness of 80um was placed into the heating chamber of a Muffle furnace, followed by introducing a nitrogen gas into the heating chamber of the Muffle furnace at 1000 sccm for 20 min;
2. the copper foil was heated to 900°C, and ethane was introduced into the heating chamber of the Muffle furnace at 100 sccm for 250 min;
3. after the reaction, introduction of ethane and heating of the copper foil were stopped, and the nickel foil was cooled to room temperature at a rate of 5°C/min, followed by stopping the introduction of nitrogen gas to obtain graphene paper on the copper foil;
4. the copper foil was dissolved using a hydrochloric acid having a concentration of 0.1 mol/L to obtain the graphene paper.

### Example 4

1. A cobalt foil having a thickness of 100um was placed into the heating chamber of a Muffle furnace, followed by introducing a mixed gas of hydrogen gas and nitrogen gas at volume ratio of 1:1 into the heating chamber of the Muffle furnace at 500 sccm for 30 min;
2. the cobalt foil was heated to 800°C, and methane was introduced into the heating chamber of the Muffle furnace at 300 sccm for 100 min;
3. after the reaction, introduction of methane and heating of the cobalt foil were stopped, and the cobalt foil was cooled to room temperature at a rate of 20°C/min, followed by stopping the introduction of the mixed gas of hydrogen gas and nitrogen gas to obtain graphene paper on the cobalt foil;
4. the cobalt foil was dissolved using a nitric acid having a concentration of 0.2 mol/L to obtain the graphene paper.

The mechanical properties of the graphene paper prepared from Examples 1 to 4 were tested using a mechanical properties tester for thin film (CETR, USA); the testing result was summarized in Table 1.

**Table 1. Testing data of the tensile strength of graphene paper**

| Sample | Example 1 | Example 2 | Example 3 | Example 4 |
|---|---|---|---|---|
| tensile strength /MPa | 437 | 284 | 316 | 334 |

As shown in table 1, the tensile strength of the preparing graphene paper is about 2 to 3 times greater than that of an aluminum foil, which is comparable with the tensile strength of steel. The tensile strength of the current aluminium foil of industrial grade is about 140 to 160Mpa, while the tensile strength of a steel is about 300 to 350Mpa.

Although the preferable embodiments of the present invention has been described and illustrated in detail, it is clearly understood that the same is not to be taken by way of limitation, it should be understood that various changes, substitutions, and alterations could be made hereto without departing from the spirit and scope of the invention as defined by the appended claims.

## Claims

1. A method of preparing graphene paper, **characterized in that** said method comprises the steps of:
S1: placing a clean substrate into a reaction chamber, followed by introducing therein a protective gas, thereby purging out air in the reaction chamber;
S2: heating said substrate at a temperature of 800 to1100°C;
S3: keep introducing a carbonaceous material into said reaction chamber for 100 to 300 min;
S4: stopping the introduction of carbonaceous material into the reaction chamber while stopping heating of said substrate, followed by cooling said substrate at a rate of 5 to 30°C/min; finally, stopping the introduction of said protective gas, thereby obtaining graphene paper on the surface of said substrate.

2. A method of preparing graphene paper according to claim 1, **characterized in that** in step S1, said protective gas is at least one of hydrogen gas, nitrogen gas and argon gas.

3. A method of preparing graphene paper according to claim 1 or 2, **characterized in that** in step S1, the flow rate of said protective gas is 50 to 1000 sccm.

4. A method of preparing graphene paper according to claim 1, **characterized in that** in step S2, the temperature of heating said substrate is 900 to 1050°C.

5. A method of preparing graphene paper according to claim 1, **characterized in that** in step S3, said carbonaceous material is at least one of methane, ethane, acetylene and ethene.

6. A method of preparing graphene paper according to claim 1, **characterized in that** in step S3, the flow rate of said carbonaceous material is 10 to 300 sccm.

7. A method of preparing graphene paper according to claim 1, **characterized in that** in step S1, said substrate is a copper foil, an iron foil, a nickel foil or a cobalt foil.

8. A method of preparing graphene paper according to claim 7, **characterized in that** said method further comprises a step of collecting said graphene paper for further treatment after step S4:
S5: dissolving said substrate from step S4 using a dilute solution of an acid or a salt solution having a concentration of 0.01 to 0.5mol/L to obtain the graphene paper.

9. A method of preparing graphene paper according to claim 8, **characterized in that** in step S4, said dilute solution of an acid is selected from dilute hydrochloric acid, dilute sulphuric acid and dilute nitric acid; said salt solution is iron chloride.
